# EUROPEAN PATENT APPLICATION

(11) **EP 4 749 508 A1**
(43) Date of publication of application: **27.05.2026**
(21) Application number: 25188330.2
(22) Date of filing: 09.07.2025
(51) Int. Cl.: G06F 30/20

(54) **SELECTABLE MODEL SIMULATION OF SOCIAL INTERACTIONS FOR CONSUMER OR CORPORATE BEHAVIOR PREDICTION**

(30) Priority: 25.11.2024 GR 20240100841
(71) Applicant: VLTN, 2018 Antwerpen (BE)
(72) Inventor: Latinopoulos, Charilaos, 16777 Athens (GR); Zavvos, Efstathios, 14121 Athens (GR); Bernat, Pauline Geneviève Lucienne, 16675 Glyfada (GR); Halatsis, Aristides, 54631 Thessaloniki (GR)
(74) Representative: Bringer IP

(57) **Abstract**

Artificial Intelligence (Al)-assisted model selection for a social interaction engine includes the establishment of a communications link to an agent-based model (ABM) from over a computer communications network and the generation of a network of social interactivity amongst actors in the network. Al-assisted model selection additionally includes a selection in the fixed storage of the host computing platform of a social interaction model for social interactions on the generated network of social interactivity, based upon a characteristic of the generated network, that include at least an opinion dynamics model or a psychological/behavioral model. Thereafter, the ABM is configured with agent and network parameters according to the selected social interaction model in order for the ABM to simulate mediated agent interactions representative of interactions amongst the actors of the generated network. Finally, an ABM based simulation is simulated for the generated network with the outcome of the simulation recorded in the fixed storage.

## Description

### BACKGROUND OF THE INVENTION

### Field of the Invention

The present invention relates to the technical field of agent-based model (ABM) simulation of social interactions and more particularly to optimized model utilization in an agent-based simulation of consumer or corporate behavior.

### Description of the Related Art

Understanding social interactions within networks and social ecosystems is critical for predicting outcomes, allocating resources, driving innovation, and creating lasting change for businesses and policymakers. Social interactions are the backbone of information exchange, behavior adoption, and established norms within a community or organization. By accurately modelling these interactions, businesses can foresee market trends, customer behaviors, and potential challenges, allowing them to strategize effectively and stay ahead of the competition.

For policymakers, understanding social interactions is essential for designing and implementing effective interventions to address critical issues. Policies are profoundly influenced by how individuals and groups interact within a community. Predictive models of social networks are crucial for anticipating the impact of policies, optimizing resource allocation, and measuring effectiveness. However, for policymakers who may lack technical expertise, the complexity of parametrizing and modeling social networks can be a significant barrier. This underscores the need for accessible and user-friendly simulation tools to facilitate data-driven decision-making without requiring advanced technical skills.

Current solutions, such as the MASON Social Network plug-in, the Java Universal Network/Graph (JUNG) library, the NodeXL social network analysis tool, the Neo4J Data Science library, and NetworkX, provide robust tools for modelling and analyzing social networks. These tools offer features like network representation, dynamic network structures, graph algorithms, and visualization capabilities. Despite their strengths, these tools are limited in their ability to handle the dynamic and complex nature of real-world social interactions between agents, where each agent acts as a node within the social network.

Existing social interaction models, including opinion dynamics and those based on psychological behavioral theories, offer valuable insights into how individuals' opinions and behaviors evolve within networks. Models like the Deffuant model, the Hegselmann-Krause model, and other statistical models of social dynamics focus on opinion dynamics, while frameworks like the Social Identity Approach (SIA) and the Dynamic Identity Model for Agents (DIMA) draw from psychological behavioral theories. However, these models are typically standalone and not seamlessly integrated into a comprehensive platform that can efficiently capture the multifaceted and evolving nature of social interactions across diverse temporal and situational contexts.

Thus, while existing tools and models provide a foundation for simulating social interactions, existing tools do not offer a comprehensive, integrated solution that can dynamically and accurately reflect real-world social behaviors. There is a clear need for an advanced, specialized platform to bridge these gaps.

### BRIEF SUMMARY OF THE INVENTION

Embodiments of the present invention address technical deficiencies of the art in respect to agent-based modeling and simulation. To that end, embodiments of the present invention provide for a novel and non-obvious method for AI-assisted selection of social interaction models. Embodiments of the present invention also provide for a novel and non-obvious computing device adapted to perform the foregoing method. Finally, embodiments of the present invention provide for a novel and non-obvious data processing system incorporating the foregoing device in order to perform the foregoing method.

In one embodiment of the invention, a method for AI-assisted model selection for a social interaction engine includes the establishment of a communications link to an agent-based model (ABM) from over a computer communications network and the generation of a network of social interactivity amongst actors in the network. The method additionally includes utilizing an AI system to analyze the characteristics of the generated network and query a database of expert knowledge and existing models in the fixed storage of the host computing platform to identify and recommend one or more suitable social interaction models for social interactions on the generated network. The social interaction models may be, for instance, an opinion dynamics model or a psychological/behavioral model. Thereafter, the ABM is configured with agent and network parameters according to the selected social interaction model or plurality of social interaction models in order for the ABM to simulate mediated agent interactions representative of interactions amongst the actors of the generated network. Finally, an ABM may be simulated for the generated network with the outcome of the ABM simulation recorded in the fixed storage.

Different aspects of the embodiment include the following individual aspects which may be included in the broad concept expressed hereinabove separately or in different combinations with one another:
- The agent parameters include behavioral drivers that influence the actions taken by the actors represented by the agents of the ABM.
- The network parameters include each of a type of the generated network and a connection type of the agents.
- The configuration of the ABM includes setting a communications parameter for the agents of the ABM to engage in interactions with one another through predefined rule-based exchanges.
- The configuration of the ABM includes setting a communications parameter for the agents of the ABM to engage in interactions with one another through natural language processing (NLP) exchanges.

In another embodiment of the invention, a data processing system uses an AI-assisted tool to recommend a configuration for a social interaction engine. The data processing system includes a host computing platform which in of itself has one or more computers, each with memory and one or processing units including one or more processing cores. The data processing system also includes an ABM. The ABM includes a multiplicity of different agents, each representative of actors in a network, so that the agents interact with one another performing actions according to controlling configuration parameters of the ABM. Finally, the data processing system includes a social interaction engine.

The social interaction engine includes computer program instructions enabled while executing in the memory of at least one of the processing units of the host computing platform to establish a communications link to the ABM from over a computer communications network. The program instructions further are operable to generate a network of social interactivity amongst actors in the network. The program instructions yet further are operable to assist the user in selecting, in fixed storage of the host computing platform, one or more social interaction models for social interactions on the generated network of social interactivity. The selection can be based upon a characteristic of the generated network, that includes at least an opinion dynamics model or a psychological/behavioral model. Other possible social interaction models can include a sociological model.

Finally, the program instructions are operable to configure the ABM with agent and network parameters according to the selected social interaction model in order for the ABM to simulate mediated agent interactions representative of interactions amongst the actors of the generated network, to execute an ABM based simulation of the generated network and to record an outcome of the ABM simulation in the fixed storage. In this way, the technical deficiencies of traditional agent-based simulation of consumer and corporate behavior through the use of a single, dedicated model are overcome owing to the AI-assisted selectability of one or more social interaction models for social interactions on a generated network of social interactivity, based upon a characteristic of the generated network, that may be, for instance, an opinion dynamics model or a psychological/behavioral model.

Additional aspects of the invention will be set forth in part in the description which follows, and in part will be obvious from the description, or may be learned by practice of the invention. The aspects of the invention will be realized and attained by means of the elements and combinations particularly pointed out in the appended claims. It is to be understood that both the foregoing general description and the following detailed description are exemplary and explanatory only and are not restrictive of the invention, as claimed.

### BRIEF DESCRIPTION OF THE SEVERAL VIEWS OF THE DRAWINGS

The accompanying drawings, which are incorporated in and constitute part of this specification, illustrate embodiments of the invention and together with the description, serve to explain the principles of the invention. The embodiments illustrated herein are presently preferred, it being understood, however, that the invention is not limited to the precise arrangements and instrumentalities shown, wherein:
Figure 1 is a pictorial illustration reflecting different aspects of AI-assisted the social interaction engine;
Figure 2 is a block diagram depicting a data processing system that has been adapted to perform one of the aspects of the process of Figure 1; and,
Figure 3 is a flow chart illustrating one of the aspects of the process illustrated in Figure 1.

### DETAILED DESCRIPTION OF THE INVENTION

Embodiments of the invention provide for an AI-assisted model selection for a social interaction engine. In accordance with an embodiment of the invention, a social interaction engine constructs a data structure defining a network of social interactivity amongst actors included therein. Different agents are then instantiated in an ABM to act on behalf of the actors in the network. The social interaction engine then selects one or more social interaction models for social interactions on the network based upon a characteristic of the network, that includes at least an opinion dynamics model or a psychological/behavioral model. As such, the social interaction engine configures the ABM with agent and network parameters according to the selected social interaction model in order for the ABM to simulate mediated agent interactions representative of interactions amongst the actors of the network. Finally, an ABM based simulation executes with respect to the network. The outcome of the ABM simulation is stored for analysis into the behavior of the actors of the network.

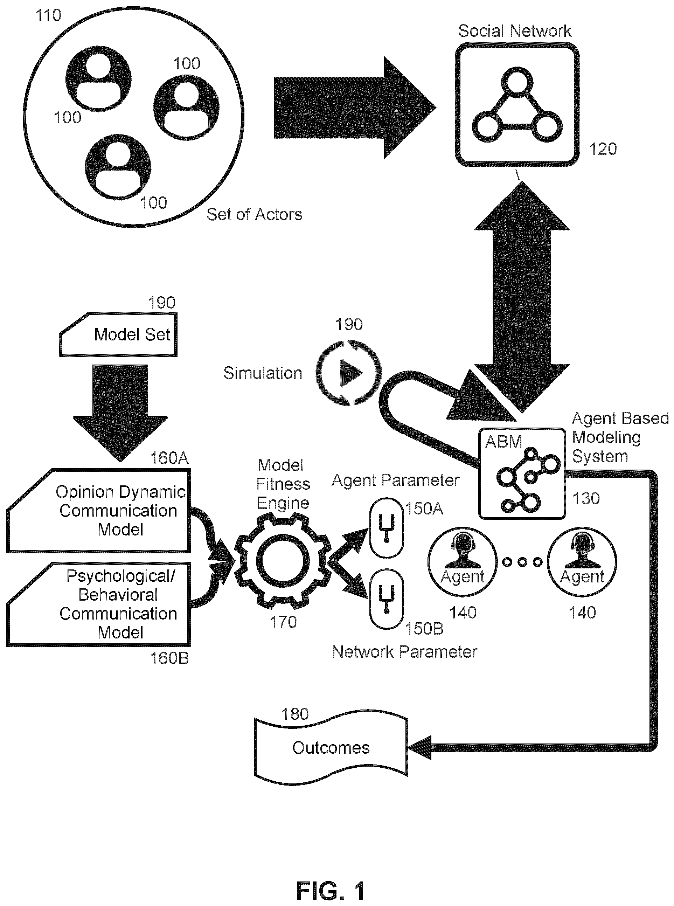

In illustration of one aspect of the embodiment, Figure 1 pictorially shows a process of AI-assisted model selection for a social interaction engine. As shown in Figure 1, a set 110 of actors 100 are defined from which a social network can be generated 120. An ABM 130 models the social network 120 with different autonomous communicating agents 140 each corresponding to one of the actors 100 in the set 110. One or more of two categories of social interaction models 160A, 160B are then selected from a model set 190 of social interaction models by model fitness engine 170 according to one or more characteristics of the social network 120. In this regard, one or more social interaction models may be selected, which could include any combination of one or more opinion dynamics social interaction models 160A and psychological/behavioral social interaction models 160B.

Thereafter, the model fitness engine 170 tunes one or more of the agent parameters 150A for the agents 140 and network parameters 150B according to the selected social interaction model from the categories 160A, 160B, such as agent connection type, or other agent or network characteristics. The model fitness engine 170 then directs a simulation 190 of the social network 120 through the interactions of the agents 140 with one another in order to produce an outcome 180 from the interactions.

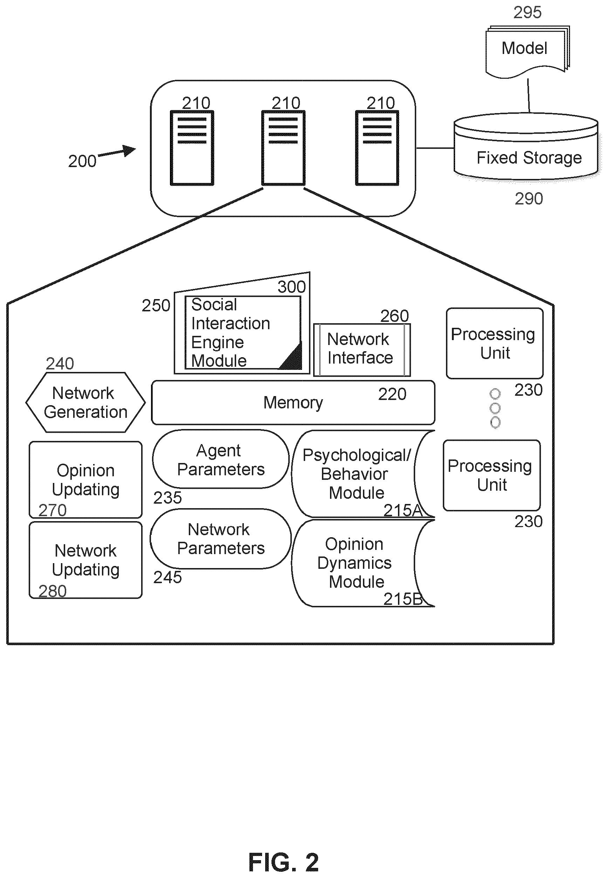

Aspects of the process described in connection with Figure 1 can be implemented within a data processing system. In further illustration, Figure 2 schematically shows a data processing system adapted to perform AI-assisted model selection for a social interaction engine. In the data processing system illustrated in Figure 1, a host computing platform 200 is provided. The host computing platform 200 includes one or more computers 210, each with memory 220 and one or more processing units 230 and fixed storage 290. The computers 210 of the host computing platform (only a single computer shown for the purpose of illustrative simplicity) can be co-located within one another and in communication with one another over a local area network, or over a data communications bus, or the computers can be remotely disposed from one another and in communication with one another through network interface 260.

Notably, a computing device 250 including a non-transitory computer readable storage medium can be included with the data processing system 200 and accessed by the processing units 230 of one or more of the computers 210. The computing device 250 stores thereon or retains therein a model fitness engine module 300. The model fitness engine module 300 includes computer program instructions which when executed by one or more of the processing units 230, performs a programmatically executable process for AI-assisted model selection.

Specifically, the program instructions during execution direct network generation logic 240 to generate a social network in the memory 220 representative of a selection of actors in a network. The program instructions further characterize the social network and, using an AI-based tool trained using previously stored data, apply the characterization in order to select from fixed storage 290, one or more social interaction models 295, which may include any combination of at least a psychological/behavior social interaction model 215A or an opinion dynamics social interaction model 215B. Once one or more of the models 215A, 215B have been selected, the program instructions invoke network updating logic 280 to update one or more of the agent parameters 235 and network parameters 245 governing the behavior and interactions of the agents in the model which models the generated social interaction network, for instance agent connection types including permissive homophily and neighbor interactions, and a type of communication such as inquiry and signaling, or natural language processing. Finally, the program instructions direct the simulation of the social network by the interaction of the agents in invoking opinion updating logic 270 to update the dynamically determined opinions of the actors in the social network.

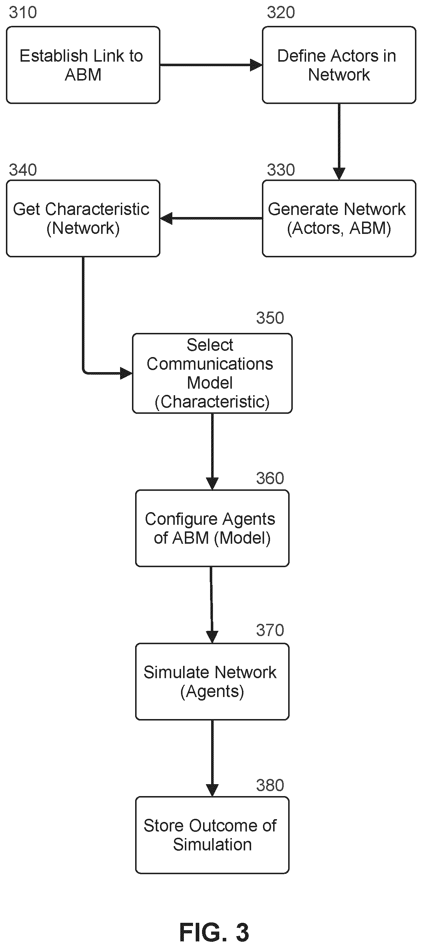

In further illustration of an exemplary operation of the module, Figure 3 is a flow chart illustrating one of the aspects of the process of Figure 1. Beginning in block 310, a communications link is established with an ABM and in block 320, one or more actors are defined in the ABM for a social network and the social network is generated in block 330 based upon the defined actors. In block 340, a characteristic of the generated network is then determined in order to select one or more social interaction models which map to the characteristic in block 350.

In block 360, the selected social interaction model or models are used to configure the network parameters and the agent parameters of the agents of the ABM. Thereafter, in block 370 the social network may be simulated by permitting the interaction of the agents of the ABM with one another. Finally, an outcome of the simulation is stored for subsequent review in block 380.

Of import, the foregoing flowchart and block diagram referred to herein illustrate the architecture, functionality, and operation of possible implementations of systems, methods, and computing devices according to various embodiments of the present invention. In this regard, each block in the flowchart or block diagrams may represent a module, segment, or portion of instructions, which includes one or more executable instructions for implementing the specified logical function or functions. In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

More specifically, the present invention may be embodied as a programmatically executable process. As well, the present invention may be embodied within a computing device upon which programmatic instructions are stored and from which the programmatic instructions are enabled to be loaded into memory of a data processing system and executed therefrom in order to perform the foregoing programmatically executable process. Even further, the present invention may be embodied within a data processing system adapted to load the programmatic instructions from a computing device and to then execute the programmatic instructions in order to perform the foregoing programmatically executable process.

To that end, the computing device is a non-transitory computer readable storage medium or media retaining therein or storing thereon computer readable program instructions. These instructions, when executed from memory by one or more processing units of a data processing system, cause the processing units to perform different programmatic processes exemplary of different aspects of the programmatically executable process. In this regard, the processing units each include an instruction execution device such as a central processing unit or "CPU" of a computer. One or more computers may be included within the data processing system. Of note, while the CPU can be a single core CPU, it will be understood that multiple CPU cores can operate within the CPU and in either instance, the instructions are directly loaded from memory into one or more of the cores of one or more of the CPUs for execution.

Aside from the direct loading of the instructions from memory for execution by one or more cores of a CPU or multiple CPUs, the computer readable program instructions described herein alternatively can be retrieved from over a computer communications network into the memory of a computer of the data processing system for execution therein. As well, only a portion of the program instructions may be retrieved into the memory from over the computer communications network, while other portions may be loaded from persistent storage of the computer. Even further, only a portion of the program instructions may execute by one or more processing cores of one or more CPUs of one of the computers of the data processing system, while other portions may cooperatively execute within a different computer of the data processing system that is either co-located with the computer or positioned remotely from the computer over the computer communications network with results of the computing by both computers shared therebetween.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

Having thus described the invention of the present application in detail and by reference to embodiments thereof, it will be apparent that modifications and variations are possible without departing from the scope of the invention defined in the appended claims as follows:

## Claims

1. An artificial intelligence (AI) model selection method for a social interaction engine, the method comprising:
establishing a communications link to an agent-based model (ABM) from over a computer communications network;
generating a network of social interactivity amongst actors in the network;
assisting the user in selecting in fixed storage of the host computing platform one or more social interaction models for social interactions on the generated network of social interactivity, based upon a characteristic of the generated network, that include at least an opinion dynamics model or a psychological/behavioral model;
configuring the ABM with agent and networks parameters according to the selected social interaction model in order for the ABM to simulate mediated agent interactions representative of interactions amongst the actors of the generated network;
executing an ABM based simulation of the generated network; and,
recording an outcome of the ABM simulation in the fixed storage.

2. The method of claim 1, wherein the agent parameters include quantifiable variables such as needs, motives, social norms or other empirically defined factors that govern the behavior and decision-making processes of the actors represented by the agents of the ABM.

3. The method of claim 1, wherein the network parameters include each of a type of the generated network and a connection type for the agents of the ABM.

4. The method of claim 1, wherein the configuration of the ABM includes setting a communications parameter for the agents of the ABM to engage in the interactions with one another through predefined rule-based exchanges.

5. The method of claim 1, wherein the configuration of the ABM includes setting a communications parameter for the agents of the ABM to engage in the interactions with one another through natural language processing (NLP) exchanges.

6. A data processing system executing artificial intelligence (AI)-assisted model selection for a social interaction engine, the data processing system comprising:
a host computing platform comprising one or more computers, each with memory and one or processing units including one or more processing cores;
an agent-based model (ABM) of a multiplicity of different agents, each representative of actors in a network, the agents autonomously interacting with one another performing actions according to controlling configuration parameters of the ABM; and,
a model fitness engine comprising computer program instructions enabled while executing in the memory of at least one of the processing units of the host computing platform to perform:
establishing a communications link to the ABM from over a computer communications network;
generating a network of social interactivity amongst actors in the network;
assist users in selecting in fixed storage of the host computing platform one or more social interaction models for social interactions on the generated network of social interactivity, based upon a characteristic of the generated network, that include at least an opinion dynamics model or a psychological/behavioral model;
configuring the ABM with agent and network parameters according to the selected social interaction model in order for the ABM to simulate mediated agent interactions representative of interactions amongst the actors of the generated network;
executing an ABM based simulation of the generated network; and,
recording an outcome of the ABM simulation in the fixed storage.

7. The data processing system of claim 6, wherein the agent parameters include quantifiable variables such as needs, motives, social norms or other empirically defined factors that govern the behavior and decision-making processes of the actors represented by the agents of the ABM.

8. The data processing system of claim 6, wherein the network parameters include each of a type of the generated network and a connection type for the agents of the ABM.

9. The data processing system of claim 6, wherein the configuration of the ABM includes setting a communications parameter for the agents of the ABM to engage in the interactions with one another through predefined rule-based exchanges.

10. The data processing system of claim 6, wherein the configuration of the ABM includes setting a communications parameter for the agents of the ABM to engage in the interactions with one another through natural language processing (NLP) exchanges.

11. A computing device comprising a non-transitory computer readable storage medium having program instructions stored therein, the instructions being executable by at least one processing core of a processing unit to cause the processing unit to perform a method for artificial intelligence (AI)-assisted model selection for a social interaction engine, the method including:
establishing a communications link to an agent-based model (ABM) from over a computer communications network;
generating a network of social interactivity amongst actors in the network;
assist user selecting in fixed storage of the host computing platform one or more social interaction models for social interactions on the generated network of social interactivity, based upon a characteristic of the generated network, that include at least an opinion dynamics model or a psychological/behavioral model;
configuring the ABM with agent and network parameters according to the selected social interaction model in order for the ABM to simulate mediated agent interactions representative of interactions amongst the actors of the generated network;
executing an ABM based simulation of the generated network; and,
recording an outcome of the ABM simulation in the fixed storage.

12. The computing device of claim 11, wherein the agent parameters include quantifiable variables such as needs, motives, social norms or other empirically defined factors that govern the behavior and decision-making processes of the actors represented by the agents of the ABM.

13. The computing device of claim 11, wherein the network parameters include each of a type of the generated network and a connection type for the agents of the ABM.

14. The computing device of claim 11, wherein the configuration of the ABM includes setting a communications parameter for the agents of the ABM to engage in the interactions with one another through predefined rule-based exchanges.

15. The computing device of claim 11, wherein the configuration of the ABM includes setting a communications parameter for the agents of the ABM to engage in the interactions with one another through natural language processing (NLP) exchanges.
